# FASCICULE DE BREVET EUROPEEN

(11) **EP 4 428 900 B1**
(45) Date de publication et mention de la délivrance du brevet: **24.09.2025**
(21) Numéro de dépôt: 24161328.0
(22) Date de dépôt: 05.03.2024
(51) Int. Cl.: H01L 21/285, H10D 64/62

(54) **PROCÉDÉ DE FORMATION D'UN CONTACT OHMIQUE SUR UNE COUCHE À BASE DE GERMANIUM-ÉTAIN**
VERFAHREN ZUR HERSTELLUNG EINES OHMSCHEN KONTAKTES AUF EINER GERMANIUM-ZINN-SCHICHT
METHOD FOR FORMING AN OHMIC CONTACT TO A GERMANIUM-TIN BASED LAYER

(30) Priorité: 06.03.2023 FR 2302062
(43) Date de publication de la demande: 11.09.2024
(73) Titulaire: Commissariat à l'Energie Atomique et aux Energies Alternatives, 75015 Paris (FR)
(72) Inventeur: COUDURIER, Nicolas, 38054 Grenoble Cedex 09 (FR); RODRIGUEZ, Philippe, 38054 Grenoble Cedex 09 (FR)
(74) Mandataire: Cabinet Camus Lebkiri

(56) Documents cités:
- QUINTERO A ET AL: "Impact of Sn content in Ge1-xSnx layers on Ni-stanogermanides solid-state reaction and properties", 2018 IEEE INTERNATIONAL INTERCONNECT TECHNOLOGY CONFERENCE (IITC), IEEE, 4 June 2018 (2018-06-04), pages 103 - 105, XP033386028, DOI: 10.1109/IITC.2018.8430475

## Description

### DOMAINE TECHNIQUE

Le domaine technique de l'invention est celui de la formation d'un contact ohmique sur une couche en un matériau semi-conducteur comprenant du germanium et de l'étain, typiquement une couche en alliage germanium-étain (GeSn) ou en alliage silicium-germanium-étain (SiGeSn).

### ÉTAT DE LA TECHNIQUE

Les alliages GeSn et SiGeSn sont apparus comme des matériaux prometteurs pour la réalisation de dispositifs microélectroniques comme les transistors à effet de champ. Par exemple, le GeSn peut être utilisé pour former un canal de haute mobilité dans les transistors à effet de champ à structure métal-oxyde-semiconducteur (ou MOSFET, pour « metal-oyde-semiconductor field effect transistor » en anglais) ou dans les transistors à effet de champ à effet tunnel (ou **TFET,** pour « tunnel field effect transistor » en anglais). Il peut également être utilisé dans les régions de drain et de source d'un MOSFET pour générer une contrainte en compression dans un canal en germanium.

Puisque l'ajout d'étain dans la structure cristalline du germanium au-delà d'un pourcentage atomique d'environ 10 % permet d'obtenir un matériau semi-conducteur à bande interdite directe, l'alliage GeSn est également utilisé pour former les couches actives (émettrices/réceptrices) de dispositifs optoélectroniques. On peut citer à titre d'exemple de dispositifs optoélectroniques les photodétecteurs p-i-n, les diodes électroluminescentes à hétérojonction et, plus récemment, les lasers à pompage optique et électrique.

Quelle que soit l'application visée, des contacts ohmiques peu résistifs avec la couche de GeSn sont nécessaires pour obtenir des dispositifs performants.

Des contacts à base de nickel ont été proposés, car le nickel permet la formation d'un alliage intermétallique Ni(GeSn) à une température compatible avec les dispositifs microélectroniques et optoélectroniques, cet alliage intermétallique présentant en outre une faible valeur de résistivité spécifique de contact (ρsc) avec la couche de GeSn et une faible valeur de résistance carrée (Rs).

Les articles [« Formation of Ni(Ge1-xSnx) layers with solid-phase reaction in Ni/Ge1-xSnx/Ge systems », Tsuyoshi Nishimura et al., Solid-State Electronics, Volume 60, Issue 1, pp. 46-52, 2011] et [« Impact of alloying elements (Co, Pt) on nickel stanogermanide formation », Andrea Quintero et al., Materials Science in Semiconductor Processing, 108, 104890, 2020] décrivent ainsi des procédés de formation de contact ohmique par réaction à l'état solide d'une couche de nickel sur une couche de GeSn.

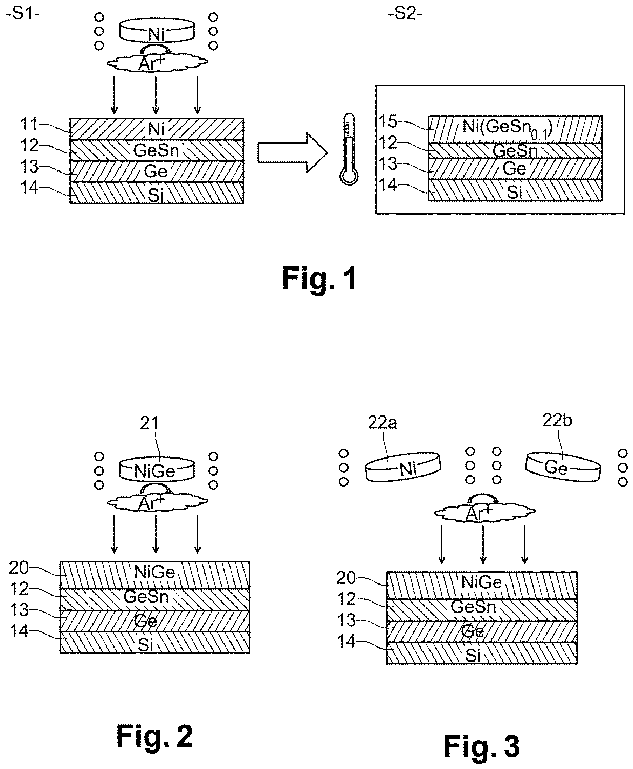

La figure 1 représente schématiquement le procédé de formation de contact ohmique décrit dans l'article de A. Quintero et al. Le procédé de formation comprend deux étapes :
- une étape S1 de dépôt par pulvérisation d'une couche de nickel 11 sur une couche de GeSn 12, la couche de GeSn 12 ayant été préalablement formée par épitaxie sur une couche tampon en germanium 13, elle-même épitaxiée sur un substrat en silicium 14 ; et
- une étape S2 de recuit de l'empilement ainsi obtenu à une température comprise entre 200 °C et 550 °C pendant 30 s, pour former une couche de Ni(GeSn) 15 en contact ohmique avec la couche de GeSn 12.

Comme indiqué dans les articles précités, les contacts Ni(GeSn) présentent une faible stabilité thermodynamique (induisant une faible stabilité thermique) liée à la ségrégation des atomes d'étain et à l'agglomération des grains de Ni(GeSn). Ces phénomènes de ségrégation et d'agglomération sont accentués lorsque la teneur en étain de la couche de GeSn augmente.

### RESUMÉ DE L'INVENTION

L'invention vise à former, sur une couche en un matériau semi-conducteur comprenant du germanium et de l'étain, un contact ohmique présentant une meilleure stabilité thermique.

Selon l'invention, on tend vers cet objectif en prévoyant un procédé de formation de contact ohmique comprenant une étape de dépôt d'une couche de nickel-germanium sur la couche de matériau semi-conducteur au moyen d'une technique de dépôt physique en phase vapeur.

De préférence, la technique de dépôt physique en phase vapeur est choisie parmi les techniques d'évaporation, notamment l'évaporation thermique et l'évaporation par faisceau d'électrons (EBPVD), les techniques de pulvérisation, notamment la pulvérisation cathodique et la pulvérisation par faisceau d'ions (IBD), le dépôt assisté par faisceau d'ion (IBAD) et l'ablation laser pulsé (PLD).

Dans un premier mode de mise en œuvre du procédé de formation, la couche de nickel-germanium est formée par pulvérisation d'une unique cible de nickel-germanium.

Dans un deuxième mode de mise en œuvre, la couche de nickel-germanium est formée par co-pulvérisation d'une cible de nickel et d'une cible de germanium.

Le procédé de formation peut comprendre en outre une étape de recuit de la couche de nickel-germanium à une température inférieure ou égale à 350 °C, ou au contraire, être dépourvu d'étape de recuit.

Le procédé de formation selon l'invention peut également présenter une ou plusieurs des caractéristiques ci-dessous, considérées individuellement ou selon toutes les combinaisons techniquement possibles :
- le matériau semi-conducteur est du germanium-étain ou du silicium-germanium-étain ;
- le matériau semi-conducteur présente un pourcentage atomique d'étain inférieur ou égal à 25 % ;
- la couche de matériau semi-conducteur appartient à un dispositif semiconducteur de type transistor à effet de champ, photodétecteur, diode électroluminescente ou laser.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes :
- la figure 1 représente schématiquement un procédé de formation de contact ohmique selon l'art antérieur ;
- la figure 2 représente schématiquement un premier mode de mise en œuvre du procédé de formation de contact ohmique selon l'invention ;
- la figure 3 représente schématiquement un deuxième mode de mise en œuvre du procédé de formation de contact ohmique selon l'invention ; et
- la figure 4 représente la résistivité spécifique de contact d'une pluralité de contacts ohmiques obtenus grâce au procédé de formation selon l'invention, avec ou sans une étape de recuit après l'étape de dépôt.

Pour plus de clarté, les éléments identiques ou similaires sont repérés par des signes de référence identiques sur l'ensemble des figures.

### DESCRIPTION DÉTAILLÉE

Les figures 2 et 3 représentent schématiquement deux modes de mise en œuvre d'un procédé de formation d'un contact ohmique sur une couche semi-conductrice 12.

La couche semi-conductrice 12 est constituée d'un matériau semi-conducteur comprenant du germanium (Ge) et de l'étain (Sn), tel que l'alliage germanium-étain (GeSn) ou l'alliage silicium-germanium-étain (SiGeSn). Elle peut être disposée sur une couche tampon en germanium 13, elle-même disposée sur un substrat en silicium 14. La couche tampon en germanium 13 et la couche semi-conductrice 12 ont par exemple été formées (successivement) par épitaxie sur un substrat 14 en silicium. Alternativement, la couche semi-conductrice 12 peut être épitaxiée directement sur un substrat en germanium.

La couche semi-conductrice 12 appartient de préférence à un dispositif semi-conducteur qui peut être un transistor à effet de champ (par exemple un MOSFET, TFET...), un photodétecteur (ex. un photodétecteur p-i-n), une diode électroluminescente (ex. une diode électroluminescente à hétérojonction) ou un laser (ex. un laser à pompage électrique et optique). Elle peut notamment former une couche active du dispositif semi-conducteur, telle qu'une couche de canal dans le cas d'un FET ou une couche d'émission ou de réception de rayonnement dans le cas des dispositifs optoélectroniques (photodétecteur, diode électroluminescente et laser). Le matériau de la couche semi-conductrice 12 présente un pourcentage atomique d'étain qui est avantageusement inférieur ou égal à 25 % (mais non nul), et de préférence compris entre 10 % et 15 % (pour obtenir un matériau semi-conducteur à gap direct).

D'une manière commune aux deux modes de réalisation, le procédé de formation de contact ohmique comprend une étape de dépôt physique en phase vapeur (ou PVD, pour « physical vapor deposition » en anglais) d'une couche en alliage de nickel-germanium (NiGe) 20 sur la couche semi-conductrice 12.

La couche de NiGe 20, électriquement conductrice, forme un contact ohmique avec la couche semi-conductrice 12 à base de GeSn, sans qu'il ne soit nécessaire d'accomplir un recuit pour initier une réaction chimique. Elle présente en outre l'avantage d'être stable thermiquement, contrairement à une couche composée de l'alliage intermétallique Ni(GeSn) et obtenue par réaction à l'état solide d'une couche de nickel. En particulier, lorsqu'elle est soumise à un traitement thermique (par exemple lors d'une étape ultérieure du procédé de fabrication du dispositif semi-conducteur), la couche de NiGe 20 ne connait pas les phénomènes de ségrégation ou d'agglomération du procédé de l'art antérieur. La morphologie et les phases cristallines de la couche de NiGe 20 n'évoluent pratiquement pas dans le temps. Ainsi, le contact ohmique NiGe/(Si)GeSn, de par sa stabilité thermodynamique, présente une meilleure résistance à l'intégration que le contact ohmique Ni(GeSn)/(Si)GeSn.

Dans le premier mode de mise en œuvre représenté par la figure 2, la couche de NiGe 20 est déposée par pulvérisation d'une unique cible 21 constituée de l'alliage NiGe. Un tel dépôt est particulièrement simple à mettre en œuvre. En revanche, il n'est pas possible de contrôler la stœchiométrie de la couche de NiGe 20, car celle-ci est fixée par la stœchiométrie de la cible 21. La cible de NiGe 21 comprend de préférence, en pourcentage atomique (at. %), 40 % à 60 % de germanium et 60 % à 40 % de nickel, et plus préférentiellement encore, 50 % de germanium et 50 % de nickel.

Dans le deuxième mode de mise en œuvre représenté par la figure 3, la couche de NiGe 20 est déposée par co-pulvérisation (ou pulvérisation simultanée) d'une première cible 22a constituée de nickel et d'une deuxième cible 22b constituée de germanium. Ce deuxième mode de mise en œuvre permet de contrôler facilement la composition de la couche de NiGe 20 déposée, en adaptant les paramètres de pulvérisation des deux cibles. Utiliser deux cibles est également plus avantageux en termes de coût, car la cible de Ni 22a et la cible de Ge 22b ne sont pas consommées à la même vitesse et se dégradent moins vite dans le temps qu'une unique cible de NiGe. En outre, cela permet une meilleure maitrise du procédé au fil du temps.

La technique de pulvérisation employée dans l'un ou l'autre de ces modes de mise en œuvre peut être la pulvérisation cathodique (en utilisant par exemple un plasma d'argon, comme représentée sur les figures 2-3) ou la pulvérisation par faisceau d'ions (ou IBD, pour « ion beam deposition » en anglais).

A titre d'exemple, la couche de NiGe 20 peut être déposée à une vitesse d'environ 0,25 nm/s par pulvérisation cathodique d'une unique cible de NiGe (Fig.2) au moyen du réacteur de pulvérisation Alliance Concept CT200, dans les conditions suivantes :
- un débit d'argon de 50 sccm (abréviation de « Standard Cubic Centimeter per Minute » en anglais, soit le nombre de cm³ de gaz s'écoulant par minute dans les conditions standard de pression et de température, i.e. à une température de 0 °C et une pression de 1013,25 hPa) ;
- une pression dans la chambre du réacteur égale à 2 mTorr, soit 0,267 Pa ;
- une puissance émise par le générateur DC du réacteur égale à 1000 W ;
- une vitesse de rotation du porte-substrat égale à 15 trs/min ; et
- une température de porte-substrat égale à 70 °C.

Une analyse par XRD (« X-Ray Diffraction » en anglais) de la couche de NiGe 20 déposée par pulvérisation a révélé la présence de quatre phases cristallines ((111), (112), (211) et (013)), autrement dit un état polycristallin.

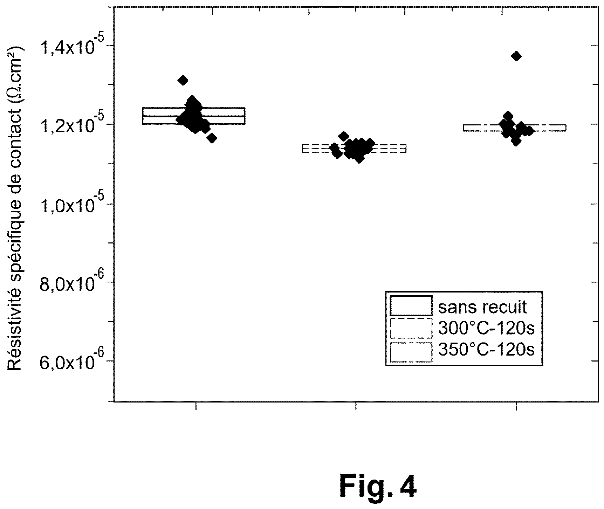

La figure 4 représente des mesures de la résistivité spécifique de contact pour trois séries d'échantillons de contact NiGe/GeSn :
- une première série d'échantillons pour laquelle le dépôt de la couche de NiGe 20 n'est pas suivi d'étape de recuit ;
- une deuxième série d'échantillons pour laquelle le dépôt de la couche de NiGe 20 est suivi d'une étape de recuit à 300 °C pendant 120 s ; et
- une troisième série d'échantillons pour laquelle le dépôt de la couche de NiGe 20 est suivi d'une étape de recuit à 350 °C pendant 120 s.

Ces mesures montrent que les contacts ohmiques NiGe/GeSn obtenus grâce au procédé de formation selon l'invention présentent une résistivité spécifique de contact comparable à celle des contacts Ni(GeSn)/GeSn et qu'en outre, cette résistivité spécifique de contact n'est que très légèrement améliorée par le recuit de la couche de NiGe à une température inférieure ou égale à 350 °C.

Ainsi, contrairement au procédé de formation par réaction à l'état solide de l'art antérieur, le procédé de formation selon l'invention peut être dépourvu d'étape de recuit après l'étape de PVD. Il est alors plus rapide (et moins couteux) à mettre en œuvre. Avantageusement, le procédé de formation selon l'invention ne comprend que l'étape de PVD (procédé en une seule étape).

Alternativement, la couche de NiGe 20 peut être soumise à un recuit à une température inférieure ou égale à 350 °C, afin d'améliorer de quelques pourcents la résistivité spécifique de contact.

Des techniques de PVD autres que les techniques de pulvérisation peuvent être employées pour former un contact ohmique NiGe sur la couche semi-conductrice 12. On peut citer à titre d'exemple les techniques d'évaporation, notamment l'évaporation thermique et l'évaporation par faisceau d'électrons (ou EBPVD, pour « electron beam PVD »). L'équipement d'évaporation peut comprendre un seul creuset contenant une source de NiGe (par exemple sous la forme de granulés ou billettes) ou deux creusets, l'un contenant une source de nickel et l'autre contenant une source de germanium.

La couche de NiGe 20 peut aussi être obtenue par un dépôt assisté par faisceau d'ions (ou IBAD, pour « ion beam-assisted deposition ») ou par ablation laser pulsé (ou PLD, pour « pulsed laser deposition »), en utilisant une unique cible de NiGe.

## Revendications

1. Procédé de formation d'un contact ohmique sur une couche (12) en un matériau semi-conducteur comprenant du germanium et de l'étain, comprenant une étape de dépôt d'une couche de nickel-germanium (20) sur la couche de matériau semi-conducteur (12) au moyen d'une technique de dépôt physique en phase vapeur.

2. Procédé selon la revendication 1, dans lequel la technique de dépôt physique en phase vapeur est choisie parmi les techniques d'évaporation, notamment l'évaporation thermique et l'évaporation par faisceau d'électrons (EBPVD), les techniques de pulvérisation, notamment la pulvérisation cathodique et la pulvérisation par faisceau d'ions (IBD), le dépôt assisté par faisceau d'ion (IBAD) et l'ablation laser pulsé (PLD).

3. Procédé selon l'une des revendications 1 et 2, dans lequel la couche de nickel-germanium (20) est formée par pulvérisation d'une unique cible de nickel-germanium (21).

4. Procédé selon l'une des revendications 1 et 2, dans lequel la couche de nickel-germanium (20) est formée par co-pulvérisation d'une cible de nickel (22a) et d'une cible de germanium (22b).

5. Procédé selon l'une quelconque des revendications 1 à 4, comprenant en outre une étape de recuit de la couche de nickel-germanium (20) à une température inférieure ou égale à 350 °C.

6. Procédé selon l'une quelconque des revendications 1 à 4, dépourvu d'étape de recuit.

7. Procédé selon l'une quelconque des revendications 1 à 6, dans lequel le matériau semi-conducteur est du germanium-étain (GeSn) ou du silicium-germanium-étain (SiGeSn).

8. Procédé selon l'une quelconque des revendications 1 à 7, dans lequel le matériau semi-conducteur présente un pourcentage atomique d'étain inférieur ou égal à 25 %.

9. Procédé selon l'une quelconque des revendications 1 à 8, dans lequel la couche de matériau semi-conducteur appartient à un dispositif semiconducteur de type transistor à effet de champ, photodétecteur, diode électroluminescente ou laser.

## Patentansprüche

1. Verfahren zum Herstellen eines ohmschen Kontakts auf einer Schicht (12) aus einem Halbleitermaterial, das Germanium und Zinn enthält, mit einem Schritt des Abscheidens einer Nickel-Germanium-Schicht (20) auf der Schicht aus Halbleitermaterial (12) mittels einer physikalischen Beschichtung aus der Dampfphase.

2. Verfahren nach Anspruch 1, bei dem die PVD-Technik ausgewählt ist aus Verdampfungstechniken, insbesondere thermischer Verdampfung und Elektronenstrahlverdampfung (EBPVD), Zerstäubungstechniken, insbesondere Kathodenzerstäubung und lonenstrahlzerstäubung (IBD), ionenstrahlunterstützter Abscheidung (IBAD) und gepulster Laserablation (PLD).

3. Verfahren nach einem der Ansprüche 1 oder 2, bei dem die Nickel-Germanium-Schicht (20) durch Sputtern eines einzelnen Nickel-GermaniumTargets (21) gebildet wird.

4. Verfahren nach einem der Ansprüche 1 und 2, bei dem die Nickel-Germanium-Schicht (20) durch gemeinsames Sputtern eines Nickeltargets (22a) und eines Germaniumtargets (22b) gebildet wird.

5. Verfahren nach einem der Ansprüche 1 bis 4, das außerdem einen Schritt des Glühens der Nickel-Germanium-Schicht (20) bei einer Temperatur von 350 °C oder weniger umfasst.

6. Verfahren nach einem der Ansprüche 1 bis 4, das keinen Glühschritt enthält.

7. Verfahren nach einem der Ansprüche 1 bis 6, bei dem das Halbleitermaterial Germanium-Zinn (GeSn) oder Silizium-Germanium-Zinn (SiGeSn) ist.

8. Verfahren nach einem der Ansprüche 1 bis 7, bei dem das Halbleitermaterial einen Prozentsatz an Zinnatomen von 25 % oder weniger aufweist.

9. Verfahren nach einem der Ansprüche 1 bis 8, bei dem die Schicht aus Halbleitermaterial zu einem Halbleiterbauelement vom Typ Feldeffekttransistor, Fotodetektor, Leuchtdiode oder Laser gehört.

## Claims

1. Method for forming an ohmic contact on a layer (12) of a semiconductor material comprising germanium and tin, comprising a step of depositing a nickel-germanium layer (20) onto the semiconductor material layer (12) by means of a physical vapour deposition technique.

2. Method according to claim 1, wherein the physical vapour deposition technique is selected from evaporation techniques, especially thermal evaporation and electron beam evaporation (EBPVD), sputtering techniques, especially cathode sputtering and ion beam sputtering (IBD), ion beam assisted deposition (IBAD) and pulsed laser deposition (PLD).

3. Method according to any of claims 1 and 2, wherein the nickel-germanium layer (20) is formed by sputtering a single nickel-germanium target (21).

4. Method according to any of claims 1 and 2, wherein the nickel-germanium layer (20) is formed by co-sputtering a nickel target (22a) and a germanium target (22b).

5. Method according to any of claims 1 to 4, further comprising a step of annealing the nickel-germanium layer (20) at a temperature less than or equal to 350°C.

6. Method according to any of claims 1 to 4, devoid of an annealing step.

7. Method according to any of claims 1 to 6, wherein the semiconductor material is germanium-tin (GeSn) or silicon-germanium-tin (SiGeSn).

8. Method according to any of claims 1 to 7, wherein the semiconductor material has an atomic percentage of tin less than or equal to 25%.

9. Method according to any of claims 1 to 8, wherein the semiconductor material layer belongs to a semiconductor device of the field-effect transistor, photodetector, light-emitting diode or laser type.
